Europäisches Patentamt

European Patent Office

Office européen des brevets

(19)

(11) Publication number: **0 045 195**
**B1**

# EUROPEAN PATENT SPECIFICATION

(12)

(45) Date of publication of patent specification: **04.09.85**

(21) Application number: **81303406.3**

(22) Date of filing: **24.07.81**

(51) Int. Cl.⁴: **H 01 L 21/443**, H 01 L 31/02 // H01L29/22

(54) Semiconductor device, a method of making a low-resistance contact between a metal and a layer of polycrystalline P-type CdTe in said semiconductor device and a cadmium-selective etchant which is useful for said method.

(30) Priority: **25.07.80 US 172049**

(43) Date of publication of application:
**03.02.82 Bulletin 82/05**

(45) Publication of the grant of the patent:
**04.09.85 Bulletin 85/36**

(84) Designated Contracting States:
**BE DE FR GB NL**

(56) References cited:
**EP-A-0 006 025**
**EP-A-0 021 774**

**INSTRUMENTS AND EXPERIMENTAL
TECHNIQUES, vol. 15, no. 1, January/February
1972, New York, US, Ya.I. VERTSIMAKHA ET
AL: "Transparent ohmic contacts with A2B6
photoconductors", pages 240-241**

(73) Proprietor: **EASTMAN KODAK COMPANY**
**343 State Street**
**Rochester New York 14650 (US)**

(72) Inventor: **Tyan, Yuan-Sheng**
**Kodak Park**
**Rochester New York (US)**

(74) Representative: **Baron, Paul Alexander Clifford
et al
Kodak Limited Patent Department Headstone
Drive
Harrow Middlesex HA1 4TY (GB)**

Courier Press, Leamington Spa, England.

## Description

This invention relates to a semiconductor device and a method of making a low-resistance contact between a metal and a layer of polycrystalline p-type cadmium telluride in said semiconductor device and a cadmium-selective etchant which is useful for said method.

Photovoltaic cells of the heterojunction type require the presence of two metal electrodes that make a low-resistance contact with the adjacent semiconductor material. If either metal electrode does not form a low-resistance contact, the characteristic I—V curve is altered and the cell does not function at its maximum potential efficiency. Of particular interest is the p-type cadmium telluride n-type cadmium sulphide cell, because of the high conversion efficiencies that are now available as reported in European Patent Application 0,006,025. The preferred metal for making ohmic contact with the p-type cadmium telluride layer has been gold, as it provides the lowest contact resistance for p-type cadmium telluride when the preparation methods of the aforesaid patent application are carried out. Other metals are useful, but they have been less desirable because their contact resistance is substantially greater. That is, a cell that uses a metal other than gold for the ohmic contact with p-type cadmium telluride, can incur as much as a 50% loss in conversion efficiency. While such a cell is still functional, its low efficiency makes it uneconomical.

A commercial drawback of the known cell is that at least due to the rapid rise in the cost of gold, gold contacts are not economical. Therefore, there is a need to provide contacts between other less expensive metals and p-type cadmium telluride, wherein contact with such metals has as low a resistance as the contact obtained when using gold as the electrode material.

Some study has been done concerning contacts for p-type cadmium telluride layers. Although there was some success in contacting p-type cadmium telluride in the single crystal form, low-resistance contact with polycrystalline, thin-film samples is recognized in Semiconductors & Semimetals, Zanio (1978), p. 203, as being much more difficult.

In the methods developed for making contacts with single-crystal cadmium telluride samples, a chemical etching step often has been used. The etchants used, however, are unsuitable for thin-film or polycrystalline samples. They either etch away the material so rapidly that much of the thin-film sample is removed, constituting waste and a danger of destroying the entire film; or attach the grain boundary of the cadmium telluride crystals selectively, causing a high concentration of defects. Hot nitric acid is an example of such an etchant.

The problem the invention intends to solve is to provide a high efficiency semiconductor device, particularly a photovoltaic cell, comprising a layer of polycrystalline p-type cadmium telluride and a layer of metal which may be a non auric metal, in low resistance contact with the cadmium telluride layer. The device should be relatively inexpensive and simple to produce.

The problem is solved by a semiconductor device, particularly a photovoltaic cell, comprising a layer (12) of polycrystalline p-type CdTe and a layer (16) of metal in low resistance contact therewith characterised in that the surface portion (18) of the CdTe layer (12) in contact with the layer (16) of metal is cadmium deficient and in that the polycrystalline structure of the surface portion (18) has intact grain boundaries.

The invention also provides a method of making a semiconductor device having a low resistance contact between a metal and a layer of polycrystalline p-type CdTe characterised by the steps of:

(a) forming a layer (12) of polycrystalline p-type CdTe on a substrate;

(b) selectively dissolving cadmium from the surface portion (18) of the layer (12) whilst leaving the polycrystalline structure of the surface portion (18) with intact grain boundaries; and

(c) applying a layer (16) of the metal in contact with the cadmium deficient surface portion.

The invention further consists in the use as an etchant for carrying out the method above described characterised in that the etchant is cadmium selective and comprises a mixture of nitric acid or salts thereof and a leveller for selective removal of cadmium from the surface of a p-type polycrystalline cadmium telluride layer without degrading the grain boundaries of said polycrystalline layer.

The present invention will now be described, by way of example, with reference to the accompanying drawings in which:—

Fig. 1 is a fragmentary, partially schematic sectional view illustrating a semiconductor device in accordance with the present invention;

Fig. 2 is an electron scanning micrograph at 10000 enlargement of a polycrystalline cadmium telluride layer remaining after etching in accordance with the method of the present invention;

Fig. 3 is an electron scanning micrograph at 10000 enlargement of a polycrystalline cadmium telluride layer after etching in accordance with the prior art.

Figs. 4 to 6 are graphs of output current versus voltage, indicating the improvement obtained by the invention.

The invention is hereinafter described by particular reference to a photovoltaic cell using polycrystalline semiconductors, a preferred embodiment. It is however applicable to any semiconductor device wherein a layer of metal is to make a low-resistance contact to p-type polycrystalline cadmium telluride that is in bulk or thin-film form, for example, in transistors, diodes and the like, as well as photovoltaic cells. The preferred devices are thin-film devices.

As used herein, "low-resistance contact" means a contact in which (for the operative voltages of the semiconductor device) the resistance in question is less than 20 ohms-cm$^2$.

It has been found that an effective interlayer comprising tellurium present between and in contact with the p-type cadmium telluride layer and the metal layer forming the contact, ensures a useful low-resistance contact regardless of the metal used. This is so provided a) the tellurium is formed by selectively dissolving the cadmium from a cadmium telluride layer, and b) the grain boundaries of the remaining cadmium telluride are left intact.

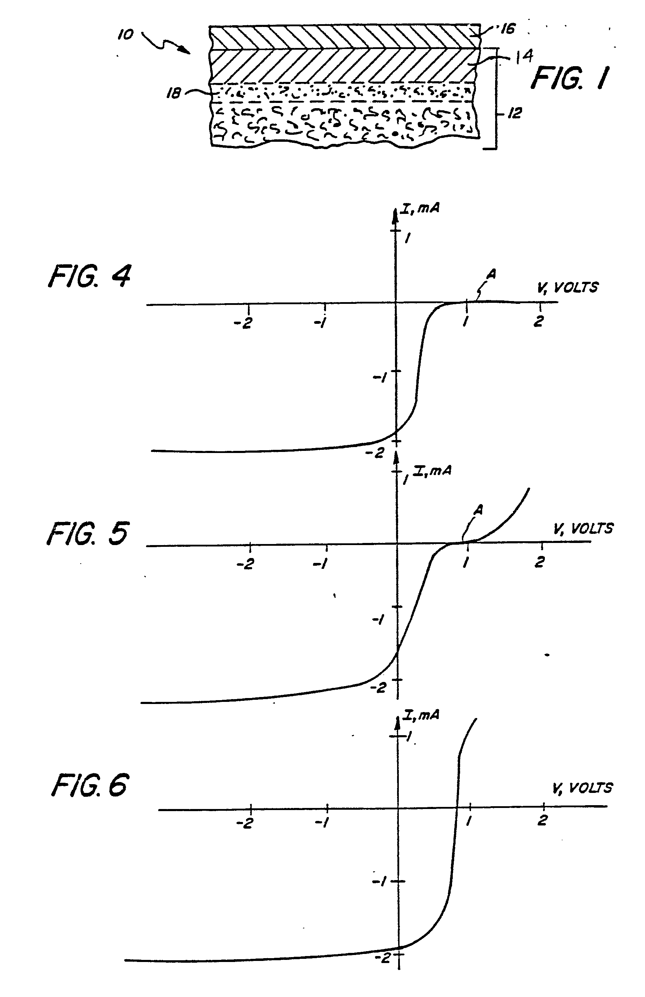

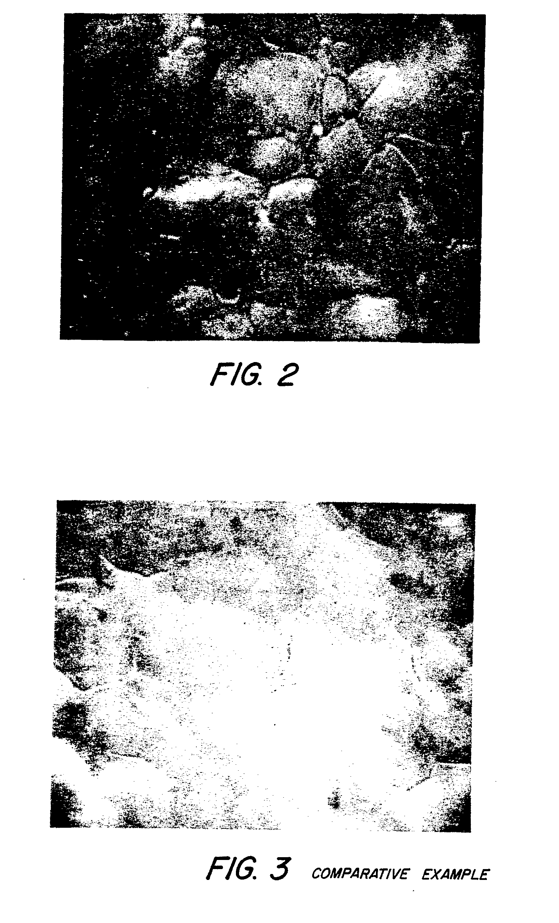

Thus, a semiconductor device 10 produced in accordance with the invention and shown in Fig. 1, comprises an operative layer 12 of polycrystalline p-type cadmium telluride. Selective dissolving of cadmium from the layer 12 forms an interlayer 14 of tellurium and, therebeneath a region 18 which is also cadmium deficient. A layer 16, of metal, contacts the interlayer 14 which, in turn, is in electrical contact with the region 18 and the rest of the layer 12 of cadmium telluride. For layer 16, any metal can be used. The most preferred metals for layer 16 are those selected from the group consisting of silver, nickel, chromium, copper, tin, aluminium, gold, titanium, lead, stainless steel, nickel alloys and various other industrial alloys.

The reasons that a low-resistance contact is made when metals other than gold are used, are not clear. This property is derived from the tellurium interlayer being formed by selectively dissolving cadmium from an initial cadmium telluride layer using an appropriate etchant. Further, this property is not present if a tellurium layer 14 were to be formed by depositing the tellurium from the vapour phase onto the cadmium telluride layer, a process that is not effective to produce a low-resistance contact without regard to the metal selected. Rather, the latter process produces contacts having much greater than 20 ohms-cm$^2$ resistance.

Preferred etchants are solutions comprising a mixture of nitric acid or salts thereof, and a levelling agent. As used herein, "levelling agent" refers to a material useful for chemical or electrolytic polishing of metals or alloys. A variety of levelling agents are useful, such as glacial acetic acid and, most preferably, concentrated phosphoric acid. A range of concentrations of nitric acid or nitrate salts are useful in this mixture with phosphoric acid, the most preferred concentration being between 0.10 and 5.0 percent by weight of the etchant. If the levelling agent is not present a much higher concentration of nitric acid is required to etch the cadmium telluride layer which can produce defects in the cadmium telluride layer, as described below with respect to Fig. 3.

Useful nitrate salts include zinc nitrate, cupric nitrate, lead nitrate and mercuric nitrate.

As will be apparent from the preceding description, the preferred method of obtaining the selective dissolution of the cadmium comprises etching the cadmium telluride layer with the etchant described above. Room temperatures are preferred for this process, although slightly higher or lower temperatures are also useful. Preferably, the length of time of the etching is between about 5 seconds and about 2 minutes.

Fig. 2 illustrates the condition of the grain boundaries of a cadmium telluride layer after using the etchant and process of the invention. The cadmium telluride layer depicted was photographed, face on, after the process of this invention had been applied to modify an initial cadmium telluride layer as described. The tellurium-containing interlayer 14 is present but cannot be seen in an electron microphotograph. The grain boundaries of the etched cadmium telluride are essentially identical to those existing in a freshly deposited polycrystalline cadmium telluride layer. That is, they are intact and substantially without degradation. In contrast, the use of an acid etchant lacking the levelling agent, such as 18% nitric acid used for 30 sec at room temperature without phosphoric acid, produces a layer as shown in Fig. 3, in which cracks along grain boundaries and other crystalline defects, which can lead to shorts, have started to appear.

The thickness of the cadmium-free or cadmium-deficient layer 14, 18 is not believed to be critical. Preferred thicknesses range from 0.5 to 50 nm.

The degree of cadmium deficiency that occurs in the region 18 of layer 12 of the device of Fig. 1, or the depth of that region, does not appear to be critical. The actual amount of cadmium lost from the surface of the cadmium telluride layer 12 will depend partly on the length of the time used to selectively dissolve the cadmium, and the effectiveness of the dissolving medium. For the purpose of this invention, the presence of the cadmium-deficient surface portion 18 is detectable by comparing the photoluminescence spectra of the cadmium telluride layer modified in accordance with this invention, against the spectra produced by the freshly formed cadmium telluride layer immediately before processing to form the tellurium-containing cadmium deficient layer 14, 18. A marked difference in the spectra is reproducibly detected. This difference is consistent with the interpretation that the surface portion 18 of layer 12 is cadmium-deficient, because relative excess amounts of tellurium, rather than cadmium produce properties that should assist, from a theoretical basis, in making a low-resistance contact with the p-type cadmium telluride layer.

The metal layer 16 is applied by any conventional technique, such as by vacuum deposition.

Photovoltaic cells prepared in accordance with this invention comprise, for example, the heterojunction cell of the aforesaid European Patent Application 0,006,025. That is, underneath the layer of p-type cadmium telluride is a polycrystalline layer of n-type cadmium sulphide, ohmic contact with a transparent or semi-transparent layer of tin oxide or indium oxide.

## Example

The following example further illustrates the invention in the light of the following controls.

## Control 1

A photovoltaic cell comprising a p-type cadmium telluride layer and an n-type cadmium sulphide layer was made following the teaching of the aforesaid European Patent Application 0006025 with the exception that the final gold electrode was not applied. The procedure was as follows: On a "Nesatron" (trade mark) glass substrate a cadmium sulphide layer was deposited at a temperature of about 550°C, in an oxygen-containing atmosphere of about 53.5 Pascals $O_2$ to a thickness of about 0.2 µm. "Nesatron" brand glass is a semitransparent electrode material comprising a conductive $In_2O_3(Sn)$ layer coated onto a transparent glass, available from PPG Industries Inc. A cadmium telluride layer about 2 µm thick was then deposited on the cadmium sulphide layer heated at a temperature of about 590°C in an atmosphere containing 200 Pascals $O_2$ and 200 Pascals Argon. A thin nickel layer (~50 nm) was evaporated, using conventional vacuum evaporation, as the positive electrode to complete the construction of the cell. The cell area was 0.1 cm². The current-voltage curve of this device under illumination was measured and presented in Fig. 4. The current saturation in the forward direction (portion A) clearly indicated an unacceptable rectifying contact between the nickel and the p-type cadmium telluride. The conversion efficiency was only about 4%.

## Control 2

A cell was made following the same procedure of Control 1, with the exception that a thin telluride layer (~20 nm) was deposited, using conventional vacuum deposition, onto the p-type cadmium telluride surface prior to the deposition of the nickel layer. Again a rectifying contact with p-type cadmium telluride is indicated by the I—V curve of the device (portion A of Fig. 5). The conversion efficiency was only about 3%.

## Invention

A cell was made following the procedure of Control 1, with the exception that the p-CdTe surface was dipped into a solution consisting of 1.25 ml of concentrated nitric acid and sufficient concentrated phosphoric acid to total 100 ml, for 30 seconds at room temperature, rinsed and air dried prior to the deposition of the nickel layer. The I—V curve indicated a much improved contact with the p-type cadmium telluride layer (Fig. 6). Furthermore, the conversion efficiency was increased to about 10% compared to the low values for Controls 1 and 2, demonstrating further the lower · contact resistance obtained by this Example compared to the Controls. That is, the higher conversion efficiency results from a lower contact resistance, as is well known.

## Control 3

As a final comparison, the procedure of the invention as above was repeated, except the etchant comprised only 100 ml of concentrated phosphoric acid. After 5 minutes of exposure of the cadmium telluride layer to this etchant, no discernable change was noted. The phosphoric acid by itself was not effective — not even in the amounts used in the effective etchant composition.

## Claims

1. A semiconductor device, particularly a photovoltaic cell, comprising a layer (12) of polycrystalline p-type CdTe and a layer (16) of metal in low resistance contact therewith characterised in that the surface portion (18) of the CdTe layer (12) in contact with the layer (16) of metal is cadmium deficient and in that the polycrystalline structure of the surface portion (18) has intact grain boundaries.

2. A device as claimed in claim 1 characterised in that the cadmium deficiency of the surface portion (18) is such that an interlayer (14) of tellurium exists between the cadmium deficient portion and the layer (16).

3. A device as claimed in claim 2 wherein the cadmium deficiency is created by selectively dissolving cadmium from one surface of the polycrystalline p-type CdTe layer (12) to form the surface portion (18) or to form the surface portion (18) and the interlayer (14).

4. A device as claimed in claim 1, 2 or 3 wherein the layer (16) of metal comprises silver, nickel, chromium, copper, tin, aluminium, gold, titanium, lead, stainless steel or a nickel alloy.

5. A method of making a semi-conductor device having a low resistance contact between a metal and a layer of polycrystalline p-type CdTe characterised by steps of:

(a) forming a layer (12) of polycrystalline p-type CdTe on a substrate;

(b) selectively dissolving cadmium from the surface portion (18) of the layer (12) whilst leaving the polycrystalline structure of the surface portion (18) with intact grain boundaries; and

(c) applying a layer (16) of the metal in contact with the cadium deficient surface portion.

6. A method as claimed in claim 5 further including the step of dissolving sufficient of the cadmium from the surface portion (18) to form an interlayer (14) of tellurium.

7. A method as claimed in claim 5 or 6 wherein the cadmium is dissolved from the surface of the CdTe layer (12) by means of an etchant comprising a mixture of $HNO_3$ or salts thereof, with a levelling agent.

8. The use for carrying out the method of claim 5, 6 or 7 of an etchant, characterised in that the etchant is cadmium selective and comprises a mixture of nitric acid or salts thereof and a leveller for selective removal of cadmium from the surface of a p-type polycrystalline cadmium telluride layer without degrading the grain boundaries of said polycrystalline layer.

9. The use of an etchant as defined in claim 8, characterised in that said levelling agent is concentrated phosphoric acid.

10. The use of an etchant as defined in claim 8 or 9, characterised in that said nitric acid or salts thereof is present in an amount of between 0.10 and 5.0 percent.

## Revendications

1. Dispositif à semi-conducteur, particulièrement une cellule photovoltaïque, comprenant une couche (12) de CdTe polycristallin, de type p, et une couche (16) de métal en contact de faible résistance avec cette dernière, caractérisé en ce que la partie superficielle (18) de la couche (12) de CdTe en contact avec la couche (16) de métal présente une déficience en cadmium, et en ce que la structure polycristalline de la partie superficielle (18) présente des arêtes de grains intactes.

2. Dispositif conforme à la revendication 1, caractérisé en ce que la déficience en cadmium de la partie superficielle (18) est telle qu'une intercouche (14) de tellure est présente entre la partie déficiente en cadmium et la couche (16).

3. Dispositif conforme à la revendication 2, dans lequel la déficience en cadmium est formée en dissolvant sélectivement le cadmium à partir d'une surface de la couche (12) de CdTe polycristallin, de type p, pour former la partie superficielle (18) ou pour former la partie superficielle (18) et l'intercouche (14).

4. Dispositif conforme à la revendication 1, 2 ou 3, dans lequel la couche (16) de métal comprend de l'argent, du nickel, du chrome, du cuivre, de l'étain, de l'aluminium, de l'or, du titane, du plomb, de l'acier inoxydable ou un alliage de nickel.

5. Procédé de préparation d'un dispositif à semi-conducteur présentant un contact à faible résistance entre un métal et une couche de CdTe polycristallin, de type p, caractérisé par les étapes suivantes:

(a) on forme une couche (12) de CdTe polycristallin, de type p, sur un support,

(b) on dissout sélectivement le cadmium de la partie superficielle (18) de la couche (12) tout en conservant la structure polycrystalline de la partie superficielle (18) avec des arêtes de grains intactes, et,

(c) on applique une couche (16) de métal en contact avec la partie superficielle déficiente en cadmium.

6. Procédé conforme à la revendication 5, qui comprend, en outre, l'étape consistant à dissoudre une quantité suffisante de cadmium à partir de la partie superficielle (18) pour former une intercouche (14) de tellure.

7. Procédé conformé à la revendication 5 ou 6, dans lequel on dissout le cadmium de la surface de la couche (12) de CdTe au moyen d'un mordant comprenant un mélange $HNO_3$ ou de ses sels avec un agent d'égalisation de la surface.

8. Moyen pour la mise en oeuvre du procédé conforme à la revendication 5, 6 ou 7, caractérisé en ce que c'est un mordant sélectif pour le cadmium qui comprend un mélange d'acide nitrique ou de ses sels avec un agent d'égalisation de la surface, pour l'élimination selective du cadmium de la surface de la couche de CdTe, polycristallin, de type p, sans dégrader les arêtes des grains de la dite couche polycristalline.

9. Mordant conforme à la revendication 8, caractérisé en ce que l'agent d'égalisation de la surface est de l'acide phosphorique concentré.

10. Mordant conforme à la revendication 8 ou 9, caractérisé en ce que l'acide nitrique, ou ses sels, est présent à une concentration comprise entre 0,10% et 5,0%.

## Patentansprüche

1. Halbleitervorrichtung, insbesondere ein Photoelement, mit einer Schicht (12) aus polykristallinem CdTe vom p-Typ und einer in niederohmigem Kontakt hiermit stehenden Schicht (16) aus Metall, dadurch gekennzeichnet, daß der Oberflächenteil (18) der CdTe-Schicht, der sich in Kontakt mit der Schicht (16) aus Metall befindet, einen Cadmiummangel aufweist und daß die polykristalline Struktur des Oberflächenteiles (18) intakte Korngrenzen hat.

2. Vorrichtung nach Anspruch 1, dadurch gekennzeichnet, daß der Cadmiummangel des Oberflächenteiles (18) derart ist, daß eine Zwischenschicht (14) aus Tellur zwischen dem einen Cadmiummangel aufweisenden Teil und der Schicht (16) existiert.

3. Vorrichtung nach Anspruch 2, dadurch gekennzeichnet, daß der Cadmiummangel dadurch hervorgerufen wird, daß aus einer Oberfläche der Schicht aus polykristallinem CdTe vom p-Typ (12) selektiv Cadmium gelöst wird, um den Oberflächenteil (18) oder den Oberflächenteil (18) und die Zwischenschicht (14) zu erzeugen.

4. Vorrichtung nach Anspruch 1, 2 oder 3, dadurch gekennzeichnet, daß die Metallschicht (16) aus Silber, Nickel, Chrom, Kupfer, Zinn, Aluminium, Gold, Titan, Blei, rostfreiem Stahl oder einer Nickellegierung besteht oder eine derartiges Metall bzw. eine derartige Legierung enthält.

5. Verfahren zur Herstellung einer Halbleitervorrichtung mit einem niederohmigen Kontakt zwischen einem Metall und einer Schicht aus polykristallinem CdTe vom p-Typ, gekennzeichnet durch die Stufen:

(a) Erzeugung einer Schicht (12) aus polykristallinem CdTe vom p-Typ auf einem Substrat;

(b) selektives Herauslösen von Cadmium aus dem Oberflächenteil (18) der Schicht (12), unter Beibehaltung der polykristallinem Struktur des Oberflächenteiles (18) mit intakten Korngrenzen und

(c) Anordnen einer Schicht (16) aus Metall in Kontakt mit dem einen Cadmiummangel aufweisenden Oberflächenteil.

6. Verfahren nach Anspruch 5, gekennzeichnet durch die weitere Stufe der Lösung einer ausreichenden Cadmiummenge aus dem Oberflächenteil (18) unter Bildung einer Zwischenschicht (14) aus Tellur.

7. Verfahren nach Ansprüchen 5 oder 6, dadurch gekennzeichnet, daß das Cadmium aus der Oberfläche der CdTe-Schicht (12) mittels eines Ätzmittels mit einer Mischung von $HNO_3$ oder Salzen hiervon mit einem Verlaufmittel herausgelöst wird.

8. Verwendung eines Ätzmittels zur Durchführung des Verfahrens von Anspruch 5, 6 oder 7, dadurch gekennzeichnet, daß das Ätzmittel Cadmium-selektiv ist und eine Mischung aus Salpetersäure oder Salzen hiervon und einem Verlaufmittel für die selektive Entfernung von Cadmium aus der Oberfläche der Schicht aus polykristallinem Cadmiumtellurid vom p-Type, ohne die Korngrenzen der polykristallinen Schicht zu zerstören, aufweist.

9. Verwendung eines ätzmittels nach Anspruch 8, dadurch gekennzeichnet, daß das Verlaufmittel konzentrierte Phosphorsäure ist.

10. Verwendung eines Ätzmittels nach Anspruch 8 oder 9, dadurch gekennzeichnet, daß die Salpetersäure oder Salze davon in einer Menge zwischen 0,10 und 5,0% vorliegen.

FIG. 1

FIG. 4

FIG. 5

FIG. 6

FIG. 2

FIG. 3 COMPARATIVE EXAMPLE